# EUROPEAN PATENT APPLICATION

(11) **EP 4 579 273 A1**
(43) Date of publication of application: **02.07.2025**
(21) Application number: 23857724.1
(22) Date of filing: 23.08.2023
(51) Int. Cl.: G01S 7/481, H05K 7/20, G05D 1/20

(54) **SENSOR DEVICE, LIDAR DEVICE, AND VEHICLE**

(30) Priority: 23.08.2022 US 202263400377 P; 29.08.2022 US 202263401742 P; 23.05.2023 US 202318322292
(71) Applicant: LG INNOTEK CO. LTD, Gangseo-gu Seoul 07796 (KR)
(72) Inventor: GARDINEER, Bayard G., Pittsburgh, Pennsylvania 15222 (US)
(74) Representative: Plasseraud IP
(86) International application number: PCT/KR2023/012494
(87) International publication number: WO 2024/043692

(57) **Abstract**

The LIDAR device disclosed in the embodiment may comprise a main frame with storage part inside; a plurality of transceivers arranged in the storage part, each irradiating a laser beam toward an object in different directions and each sensing a laser beam reflected from the object; bottom frame located at the bottom of the main frame; and a plurality of lens hoods arranged on the incident side of each of the receiving optical systems of the plurality of transceivers.

## Description

### [Technical Field]

The invention relates to a sensor device and a LIDAR device. The invention relates to a vehicle having a rotatable sensor device and a LIDAR device.

### [Background Art]

Autonomous vehicles (AVs) use multiple sensors to achieve situational awareness. The sensors that are part of the self-driving system (SDS) of the AV may comprise one or more cameras, Light Detection and Ranging (LIDAR) devices, and inertial measurement units (IMUs). Sensors such as cameras and LIDAR are used to capture and analyze the surrounding scene of the vehicle. The captured scene is then used to detect objects, including static objects such as fixed structures and dynamic objects such as pedestrians and other vehicles. The data collected from the sensors may also be used to detect conditions such as road markings, lane curvature, traffic lights, and signs. Also, a scene representation such as a 3D point cloud acquired from the LIDAR of the vehicle may be combined with one or more images acquired from the cameras to provide additional insight into the scene or situation around the vehicle.

Also, the LIDAR transceiver may comprise a transmitter that transmits light in the ultraviolet (UV), visible, and infrared spectral regions, and/or one or more photodetectors that convert other electromagnetic radiation into an electrical signal. To provide high-fidelity object detection and tracking (i.e., minimal or no distortion or noise), an optical sensor such as a LIDAR must be rigidly secured to one another and have sufficient spacing between the optical components and the transceiver assemblies, processing and driver circuitry, cooling elements, cleaning elements, wiring, and motor assemblies. Also, the transceiver components are rigidly secured to one another and must withstand the high-speed rotation, automotive-grade vibrations for a mechanical LIDAR assembly, along with balance and weight considerations. Also, the LIDAR must also comprise housing packaging and aesthetic considerations must also be taken into account.

### [Disclosure]

### [Technical Problem]

Embodiments of the invention may provide a sensor device and a LIDAR device having a plurality of transceivers.

Embodiments of the invention may provide a sensor device and a LIDAR device having a plurality of transceivers that irradiate and sense laser beams in different directions.

Embodiments of the invention may provide a sensor device and a LIDAR device in which lens hoods of different sizes are arranged on the incident side of each transceiver in different directions.

Embodiments of the invention may provide a sensor device and a LIDAR device having a plurality of transceivers that irradiate laser beams in different directions and sense the laser beams at different incident angles. Accordingly, a device having a plurality of transceivers having different performance specifications and operational purposes may be provided.

An embodiment of the invention may provide a sensor device and a LIDAR device having a first transceiver that irradiates a laser beam in a first direction and senses it at a first angle of view and a second transceiver that irradiates a laser beam in a direction opposite to the first direction and senses it at a second angle and rotating on an axis.

By including a pair of transceivers oriented in opposite directions to provide a compact rotating assembly, embodiments of the invention may provide a sensor device and a LIDAR device capable of reducing weight and aerodynamic drag and/or wind noise due to high-speed rotation.

Embodiments of the invention may provide a sensor device and a LIDAR device that provide for improvement of the inertial mass effect of the optical sensor while rotating so that the centers of gravity of each transceiver are diametrically opposite to each other with respect to the center of rotation.

Embodiments of the invention may provide a sensor device and a LIDAR device having a rigid structure that allows modular attachment of components such as cooling elements, window elements, cleaning elements, etc., has an accommodation space, and provides sufficient sealing from external and weather elements.

An embodiment of the invention may provide transceivers arranged in parallel along both side walls of an outer housing. The invention may provide heat dissipation members within the outer housing to absorb and dissipate heat generated from the transceivers. An embodiment of the invention may comprise a lens part arranged on one side or front of each transceiver and a heat dissipation member arranged on the other side or rear of each transceiver. Each heat dissipation member may have a shape corresponding to a cylindrical shape of the outer housing and may be brought into contact with a first window on one side or front of a first transceiver and a second window on the other side or rear of a second transceiver adjacent thereto.

Embodiments of the invention provide a sensor device and a LIDAR device capable of preventing optical interference, or crosstalk, between two or more transceivers. The invention also comprises improvements in inertial mass effects in a rotating LIDAR device. That is, the centers of gravity of each of the transceivers may be positioned opposite to each other with respect to the center of rotation, thereby minimizing flow when rotating by each transceiver.

According to an embodiment of the invention, a mounting device for a sensor device and a LIDAR device is provided that comprises a plurality of storage parts, for example, six fascias. The individual storage parts comprise structural features for receiving one or more components of a sensor assembly. For example, at least one of the six storage parts may be configured to receive modular cooling elements. Similarly, at least one of the six storage parts is configured to receive a modularly removable optical window. At least one of the six storage parts may be configured to ruggedly secure transceiver assemblies. Thus, the mounting device may accommodate a plurality of different component types and provide a rugged mounting structure.

Accordingly, the present invention provides a mounting device for a transceiver that provides a rigid structure, allows modular attachment of components such as cooling elements, window elements, cleaning elements, etc., provides space for accommodating the elements, and provides sufficient sealing from external and weather elements.

In accordance with an embodiment of the invention, a LIDAR sensor system is provided that comprises a housing for holding the elements in place and housing electronics, optical elements, cooling elements, and architectural or structural elements. The enclosure is provided to provide a functional and aesthetic solution to the LIDAR sensor system and may be designed to maximize the inflow and outflow of air for cooling and cleaning purposes. The enclosure may also provide an aerodynamic housing for the LIDAR sensor system.

### [Technical Solution]

A LIDAR device according to an embodiment of the invention may comprise a main frame having a storage part inside; a plurality of transceivers arranged in the storage part, each irradiating a laser beam toward an object in different directions and each sensing a laser beam reflected from the object; a bottom frame arranged below the main frame; and a plurality of lens hoods arranged on the incident side of the receiving optical system of each of the plurality of transceivers.

According to an embodiment of the invention, the plurality of transceivers may comprise a first transceiver having a first light source array emitting a laser beam in a first direction, and a first receiving optical system and a first sensor array for receiving the laser beam of the first light source array; and a second transceiver having a second light source array emitting a laser beam in a direction opposite to the first direction, and a second receiving optical system and a second sensor array for receiving the laser beam of the second light source array, and the plurality of lens hoods may comprise a first lens hood arranged on an incident side of the first receiving optical system, and a second lens hood arranged on an incident side of the second receiving optical system.

According to an embodiment of the invention, the invention may comprise a first window arranged on the incident side of the first lens hood and the emission side of the first light source array, and a second window arranged on the incident side of the second lens hood and the emission side of the second light source array.

According to an embodiment of the invention, the first and second windows may be positioned outside the main frame.

According to an embodiment of the invention, each side of the main frame may have a penetrated storage part, and each of the storage parts on each side of the main frame may comprise frames having a heat dissipation member coupled thereto.

According to an embodiment of the invention, the sizes of the entrances through which the laser beams of the plurality of lens hoods are incident may be different from each other.

According to an embodiment of the invention, the end-side lens hole of the first lens hood may have a vertical height greater than a horizontal length.

According to an embodiment of the invention, the end-side lens hole of the second lens hood may have the same horizontal length and vertical height.

According to an embodiment of the invention, a first optical axis passing through the centers of the first lens hood and the lenses of the first receiving optical system may be inclined with respect to a second optical axis passing through the centers of the second lens hood and the lenses of the second receiving optical system.

According to an embodiment of the invention, a heat dissipation cover is comprised that covers each of the heat dissipation members arranged on each side of the main frame, and the heat dissipation cover may have a hole that exposes the window.

According to an embodiment of the invention, a housing covering the upper and outer sides of the main frame is comprised, and the housing may have window holes corresponding to the holes of each of the heat dissipation covers.

According to an embodiment of the invention, the invention comprises a fixed frame fixed to a moving body and having a stator; and a rotating frame having a rotor opposed to the stator and rotating about an axis on the fixed frame. The rotating frame may rotate the main frame, the bottom frame, and the plurality of transceivers.

According to an embodiment of the invention, the reception angles of light incident through each of the transceivers among the multiple transceivers may be different from each other.

Further scope of applicability of the present invention will become apparent from the detailed description given below. However, the detailed description and specific examples, while indicating preferred embodiments of the present invention, are given by way of illustration only. This is because various changes and modifications within the spirit and scope of the present invention will become apparent to those skilled in the art from this detailed description. The present invention will be more fully understood from the detailed description given below and the accompanying drawings, which are given by way of illustration only and are therefore not intended to limit the present invention.

### [Advantageous Effects]

According to an embodiment of the invention, the invention may enable and support modular attachment of components such as cooling elements, window elements, cleaning elements, etc. to be combined, and may provide sufficient protection and sealing effect from external impact and weather elements. Also, the components may be accommodated and supported, so that the protection and combination of the components may be facilitated. Also, a device capable of detaching the components may be provided.

According to an embodiment of the invention, by having a pair of transceivers arranged in different or opposite directions, the device may be miniaturized and the weight, aerodynamic drag and/or wind noise due to high-speed movement may be reduced. Also, the packaging efficiency of the sensor head assembly may be improved. Also, optical interference caused by different transceivers may be prevented.

Also according to an embodiment of the invention, a lens hood may be placed for each transceiver's optical reception to minimize light loss or light divergence.

According to the invention, heat dissipation efficiency may be improved by arranging heat dissipation members on two or more sides.

Embodiments of the invention may obtain optical impressions at different divergence angles from different directions through a rotating imaging device such as a sensor device and a LIDAR device, thereby improving sensing efficiency for a surrounding area.

### [Description of Drawings]

FIG. 1 is a perspective view of a vehicle having a LIDAR device according to an embodiment of the invention.
FIG. 2 is an example of a block diagram of a vehicle system having the LIDAR device of FIG. 1.
FIG. 3 is a block diagram showing the first and second transceivers of the LIDAR device of FIG. 2.
FIG. 4 is a perspective view of a LIDAR device according to an embodiment of the invention.
FIG. 5 is an example of a perspective view of the LIDAR device of FIG. 4.
FIG. 6 is a perspective view of the housing of the LIDAR device of FIG. 4.
FIG. 7 is a plan view showing the internal configurations of the LIDAR device of FIG. 4.
FIG. 8 is an exploded perspective view of the internal and external configurations of the frames in the LIDAR device of FIG. 4.
FIG. 9 (A)(B) is a cross-sectional view showing a first transceiver and a second transceiver coupled within a main frame in a LIDAR device of the invention.
FIG. 10 is a partial cross-sectional view of the first and second transceivers in the LIDAR device of the invention.
FIG. 11 is a perspective view showing an example of a combination of the first frame and the first transceiver of FIG. 8.
FIG. 12 is a perspective view showing an example of a combination of the second frame and the second transceiver of FIG. 8.
FIG. 13 is a drawing for explaining the beam path and center of the first and second transceivers in the LIDAR device of the invention.
FIG. 14 is a drawing for explaining the beam paths of the first and second transceivers in the LIDAR device of the invention.
FIG. 15 is a side view of the LIDAR device of the invention, in which an end of the first lens hood of the first transceiver is coupled.
FIG. 16 is a side view of the LIDAR device of the invention, in which an end of the second lens hood of the second transceiver is coupled.
FIG. 17 is a perspective view of the first lens hood in the LIDAR device of the invention.
FIG. 18 is a perspective view of a second lens hood in the LIDAR device of the invention.
FIG. 19 is a side view showing the first lens hood and the first window of the first transceiver in the LIDAR device of the invention.
FIG. 20 is a side view showing the second lens hood and the second window of the second transceiver in the LIDAR device of the invention.

### [Best Mode]

Hereinafter, embodiments will be described in detail with reference to the accompanying drawings, in which like reference numerals designate similar elements. This invention may, however, be embodied in many different forms and should not be construed as limited to the embodiments set forth herein. Rather, these embodiments are provided as examples so that this disclosure will be thorough and complete, and will fully convey the features and functions of the present invention to those skilled in the art. Accordingly, processes, elements, and techniques that are not necessary for those skilled in the art to fully understand the features and functions of the present invention may not be described. Unless specifically stated otherwise, like reference numerals designate similar elements in the accompanying drawings and written description, and therefore the description thereof will not be repeated.

A LIDAR system may be referred to as a depth detection system, a laser ranging system, a laser radar system, a LIDAR system, or a laser/light detection and ranging (LADAR) system. LIDAR is a type of distance measurement sensor characterized by long detection range, high resolution, and little interference from the environment. LIDAR has been widely applied in the fields of intelligent robots, unmanned aerial vehicles, autonomous driving, or self-driving. The working principle of LIDAR is to estimate the distance based on the round-trip time (e.g., flight time or delay time) of electromagnetic waves between a source and a target.

Typically, LIDAR systems, such as a direct time-of-flight (D-TOF) LIDAR system, emit a light pulse (e.g., a laser pulse) toward an object. By measuring the time it takes for the light pulse to reflect off the object and be detected by a sensor in the LIDAR system, the distance to the object (e.g., depth) is measured. For example, to reduce noise from ambient light, repeated measurements may be made to generate individual histograms of relative times-of-flight (TOF) values based on the repeated measurements. The peaks of the individual histograms may be calculated to detect events (e.g., to detect the depth of a point or region of an object that reflects the light pulse back).

The aspects and features of embodiments of the present invention will be described in more detail with reference to the drawings.

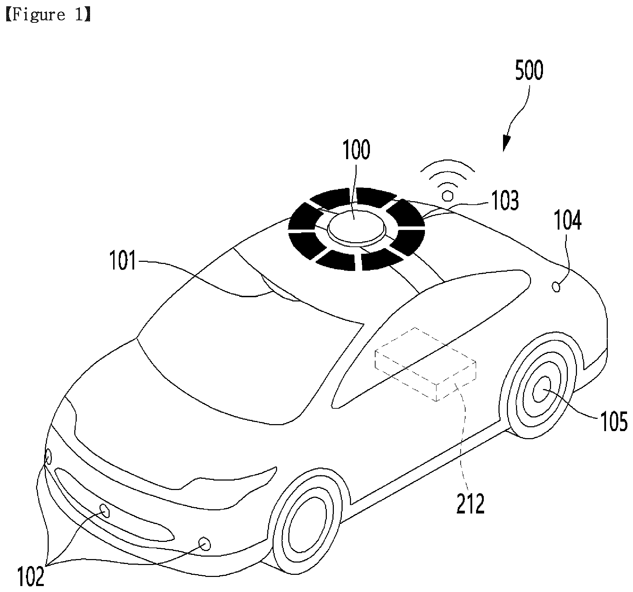

FIG. 1 is a perspective view of a vehicle having a LIDAR device according to an embodiment of the invention.

Referring to FIG. 1, a moving object such as a vehicle (500) may comprise a LIDAR device (100), a camera unit (101), a vehicle recognition sensor (102, 104), a GPS (Global Positioning System) sensor (103), a vehicle control module (212), and an ultrasonic sensor (105).

The LIDAR device (100) is a rotating imaging device or sensor device, which is attached to a part of a vehicle (500), rotates 360 degrees, senses the distance between the vehicle and an object (static object, dynamic object), the surrounding environment, and the shape, and controls driving using the measured data. Using this sensing technology, a 3D point cloud may be used to collect and analyze surrounding objects or environments of the vehicle, and sensed data that provides information on objects located within an appropriate proximity range may be generated.

The LIDAR device (100) may communicate with the vehicle control module (212) and transmit/receive information according to the driving of the vehicle. The vehicle control module (212) communicates with various systems or sensors inside the vehicle and may perform various controls. The vehicle control module (212) is a device that controls and monitors various systems of the vehicle and may comprise a control device such as an electronic control unit (ECU). The vehicle control module (212) may communicate with an external mobile device and be electrically connected to a removable storage device.

The camera unit (101) may be mounted one or more times inside and/or outside the vehicle, and may capture images of the front and/or the rear of the moving vehicle and provide or store the captured images through a display device (not shown). The captured image data may optionally comprise audio data. As another example, the camera unit (101) may be mounted at the front, rear, each corner, or each side of the vehicle (500), capture images of the surroundings of the vehicle, and provide the images through a display device (not shown). The vehicle control module (212) or another processor may identify traffic lights, vehicles, pedestrians, etc. based on the data captured by the camera unit (101), and provide the acquired information to the driver. This camera unit (101) may be used as a driving assistance device.

A plurality of front radars (102) are installed in front of the vehicle (500) and detect the distance between the vehicle (500) and a front object. A plurality of rear radars (104) are installed in rear of the vehicle (500) and detect the distance between the vehicle (500) and a rear object. When there is object information detected through these radars (102, 104), the driver is notified of surrounding objects or obstacles by an alarm or warning message.

The GPS sensor (103) may receive signals from satellites and provide them to devices such as a vehicle control module (212), a LIDAR device (100), and a camera unit (101). The devices may provide or calculate information such as the vehicle's location, speed, and time based on the GPS location signal.

The ultrasonic sensor (105) may provide convenience by sensing the distance from a nearby vehicle or obstacle, so that the vehicle may be safely parked in a parking space. Also, the ultrasonic sensor (105) may prevent accidents that may occur while driving. The ultrasonic sensor (105) may be installed on the rear or side of the vehicle, or on the wheels, etc.

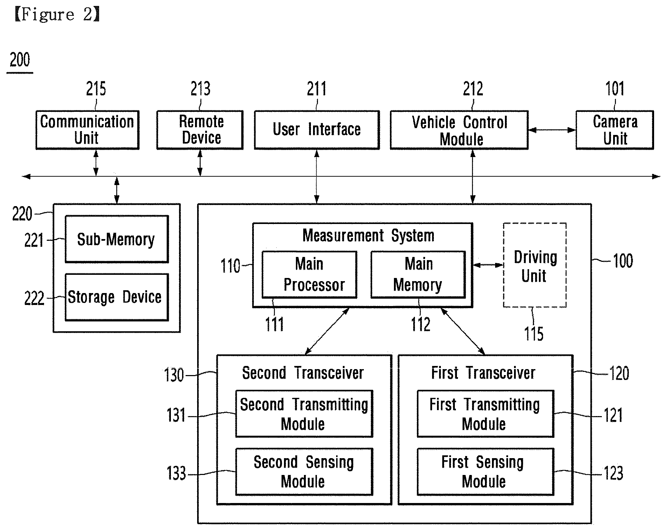

As shown in FIG. 2, a vehicle system (200) having a LIDAR device (100) and a vehicle control module (212) receives input from a user or driver or provides information to a user or driver through a user interface (211). The user interface (211) may comprise a display device, a touch panel, a button, voice recognition, a wired or wireless input device, and is connected wired or wirelessly to enable communication between the driver and various devices.

The vehicle system (200) communicates with a remote device (213), and the remote device (213) may remotely communicate with a user or an external device or receive an external control signal. The communication unit (215) may support wired or wireless communication, and may be, for example, a wired or wireless module.

The storage unit (220) may comprise one or more sub-memories (221) therein. Also, the storage unit (220) may comprise a portable or removable storage device (222). The LIDAR device (100) may communicate with a user interface (211) and a camera unit (101).

The LIDAR device (100) comprises a driving unit (115) such as a motor, and the driving unit (115) may rotate part or all of the LIDAR device (100) 360 degrees by a control signal. The driving unit (115) communicates with an internal component of the LIDAR device (100), for example, a measurement system (110), and enables the LIDAR device (100) to rotate about its axis.

The LIDAR device (100) may comprise a measurement system (110) and at least one transceiver (120, 130). The driving unit (115) is coupled so that the measurement system (110) and the transceiver (120, 130) may rotate and transmit driving force.

The measurement system (110) may comprise a main processor (111) and a main memory (112). The main processor (111) may be implemented as a general purpose processor, an Application Specific Integrated Circuit (ASIC), one or more Field Programmable Gate Arrays (FPGAs), a group of processing elements, or other suitable electronic processing elements. The main memory (e.g., memory, memory unit, storage device, etc.) (112) may comprise one or more devices (e.g., RAM, ROM, flash memory, hard disk storage, etc.) for storing data and/or computer code for completing or facilitating the various processes described herein. The main memory (112) may be or comprise volatile memory or nonvolatile memory. The main memory (112) may comprise a database component, an object code component, a script component, or any other type of information structure to support the various activities and information structures described herein. In an embodiment, the main memory (112) may be communicatively coupled to the main processor (111).

The measurement system (110) may comprise one or more processors (also referred to as central processing units or CPUs). The one or more processors may be connected to a communication infrastructure or bus. Also, each of the one or more processors may be a graphics processing unit (GPU). In some examples, a GPU (graphics processing unit) may comprise a processor, which is a specialized electronic circuit designed to process mathematically intensive applications. A GPU may have a parallel architecture that is efficient for parallel processing of large blocks of data, such as mathematically intensive data commonly used in computer graphics applications, images, videos, etc.

The measurement system (110) is a computer system and may be connected to one or more user input/output devices, such as a monitor, keyboard, pointing device, etc., that communicate with a communication infrastructure through a user input/output interface.

In the LIDAR device (100), one or more, for example, a plurality of, transceivers (120, 130) may be arranged. The plurality of transceivers (120, 130) may irradiate and sense laser beams in different directions with respect to a rotation axis. Here, the different directions may range from 10 degrees to 180 degrees with respect to each other. For example, the plurality of transceivers (120, 130) may be arranged at any one of 30 degrees, 60 degrees, 90 degrees, 120 degrees, 150 degrees, and 180 degrees. Preferably, the plurality of transceivers (120, 130) may be arranged at an angle of 180 degrees.

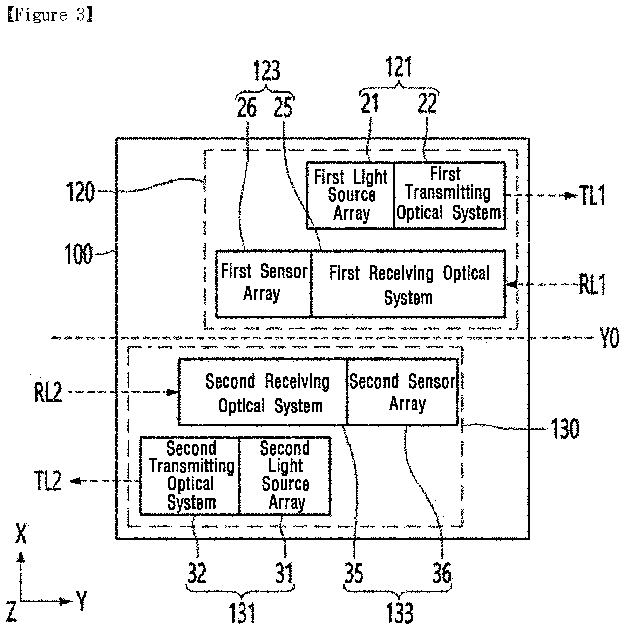

As shown in FIG. 3, the plurality of transceivers (120, 130) may irradiate and sense laser beams in opposite directions. To this end, the light source arrays (21, 31) of the plurality of transceivers (120, 130) may be positioned at opposite sides, and the receiving optical systems (25, 35) may be arranged in opposite directions at the inner center of the LIDAR device (100).

The plurality of transceivers (120, 130) may have different divergence angles or angles of view. The plurality of transceivers (120, 130) may scan an object at different altitudes. Since the plurality of transceivers (120, 130) are provided inside, the rotational imaging device may be miniaturized, and the weight may be distributed to achieve rotational balance. The plurality of transceivers (120, 130) may have different vertical angles of view (i.e., altitudes). The plurality of transceivers (120, 130) may have different horizontal angles of view.

The plurality of transceivers (120, 130) may comprise a first transceiver (120) and a second transceiver (130). The first transceiver (120) may comprise a first transmitting module (121) and a first sensing module (123), and the second transceiver (130) may comprise a second transmitting module (131) and a second sensing module (133). The first transmitting module (121) of the first transceiver (120) transmits a laser beam, and the first sensing module (123) senses the laser beam transmitted by the first transmitting module (121). The second transmitting module (131) of the second transceiver (130) transmits a laser beam, and the second sensing module (133) senses the laser beam transmitted by the second transmitting module (131).

As shown in FIG. 3, the first transmitting module (121) may comprise a first light source array (21) and a first transmitting optical system (22). The first sensing module (123) may comprise a first receiving optical system (25) and a first sensor array (26). The first transmitting module (121) irradiates a first transmitting laser beam (TL1) toward an object, and the first sensing module (123) senses a first receiving laser beam (RL1) reflected from the object.

The second transmitting module (131) may comprise a second light source array (31) and a second transmitting optical system (32). The second sensing module (133) may comprise a second receiving optical system (35) and a second sensor array (36). The second transmitting module (131) irradiates a second transmitting laser beam (TL2) toward an object, and the second sensing module (133) senses a second receiving laser beam (RL2) reflected from the object.

The first transmitting laser beam (TL1) is irradiated in the first direction (Y), and the second transmitting laser beam (TL2) is irradiated in a direction opposite to the first direction. That is, the first and second transmitting laser beams (TL1, TL2) irradiate light in 180 degree opposite directions based on the center position, and scan objects placed 180 degrees apart.

The first and second transmitting modules (121, 131) may comprise a processor or control module such as a general-purpose processor, ASIC, or FPGA capable of controlling the driving of the first and second light source arrays (21, 31) and the transmission of light signals. Also, the first and second transmitting modules (121, 131) may have an internal memory in which a code for controlling the generation of a laser beam is stored.

The first and second light source arrays (21, 31) may comprise one-dimensional or two-dimensional arrays and may be individually addressable or controllable. The first and second light source arrays (21, 31) may comprise a plurality of light sources that generate laser beams or light pulses. The light sources may comprise light sources such as a laser diode (LD), an edge emitting laser, a vertical-cavity surface emitting laser (VCSEL), a distributed feedback laser, a light emitting diode (LED), and a super luminescent diode (SLD). However, it is not limited to this.

The first and second light source arrays (21, 31) may comprise a plurality of electrically coupled surface-emitting laser diodes, such as VCSEL arrays, each emitter being individually addressable or controllable. The first and second light source arrays (21, 31) may be implemented as a one-dimensional (Q*P) VCSEL array or a two-dimensional array having Q rows and P columns. Here, Q, P ((columns, rows) may be 2 or more (Q > P). Also, each VCSEL array may be grouped in plurality to form each light source. The number of light sources in the first and second light source arrays (21, 31) may be the same or different.

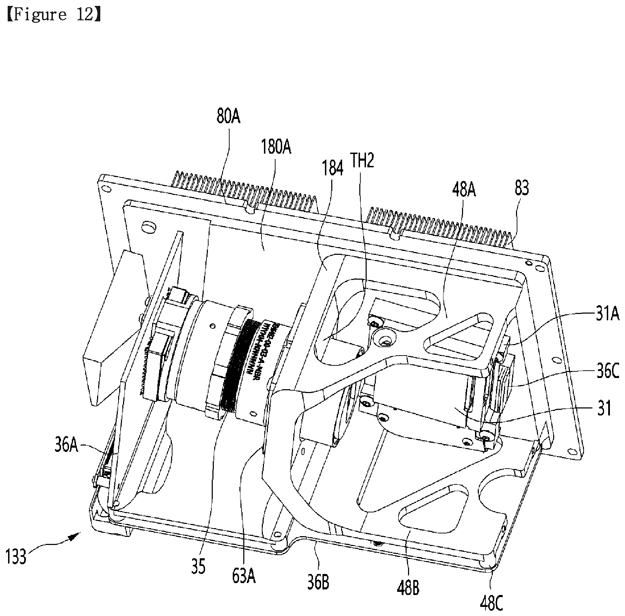

The optical signals emitted from the first and second light source arrays (21, 31) may be irradiated toward an object through the first and second transmitting optical systems (22, 32). The first and second transmitting optical systems (22, 32) may comprise one or more lenses, or one or more lenses and a micro lens array (26C, 36C, see FIG. 12) in front of the lenses. The first and second transmitting optical systems (22, 32) may comprise one or more optical lens elements so that the laser beams may be shaped in a desired manner. That is, the first and second transmitting modules (121, 131) may set the irradiation direction or irradiation angle of the light generated from the first and second light source arrays (21, 31) according to the control of the main processor (111). Also, the LIDAR device (100) may comprise a beam splitter (not shown) therein for overlapping or separating the first transmitting laser beam (TL1) and the first receiving laser beam (RL1).

The first and second transmitting modules (121, 131) may irradiate with pulsed light or continuous light, and may transmit plurality of time toward the object to be scanned. The main processor (111) may generate a start signal at the time of transmitting light, and provide it to a TDC (Time to digital converter). The start signal may be used for calculating the time of flight (TOF) of light.

The first and second sensing modules (123, 133) may comprise a processor having a matching filter, a peak detection circuit, and a SPAD saturation and quenching circuit, which converts a raw histogram based on a signal sensed through the first and second receiving optical systems (25, 35). The processor may be implemented as a general-purpose processor, an ASIC (Application Specific Integrated Circuit), one or more FPGAs (Field Programmable Gate Arrays), a group of processing components, or other suitable electronic processing components. The first and second sensing modules (133, 133) may comprise a memory (not shown) having one or more devices (for example, RAM, ROM, flash memory, hard disk storage, etc.) for storing an optical signal detected therein.

The first and second sensor arrays (26, 36) may receive laser beams (RL1, RL2) reflected or scattered from an object through the first and second receiving optical systems (22, 32). The first and second sensor arrays (26, 36) may comprise detectors divided into a plurality of pixels, and a light detection element may be arranged in each of the plurality of pixels. The first and second receiving optical systems (22, 32) may be optical elements for focusing reflected light onto a predetermined pixel.

The first and second sensing modules (123, 133) may convert the reflected light into a stop signal when the reflected light is received by the first and second sensor arrays (26, 36). The stop signal may be used to calculate the time of flight of light together with the start signal. The first and second sensor arrays (26, 36) or the first and second sensing modules (123, 133) may comprise a TDC for measuring the time of flight of light detected by each of the plurality of light detectors. The light detector may be a light-receiving element that generates an electric signal by the detected light energy.

The first and second sensor arrays (26, 36) may be implemented as a one-dimensional or two-dimensional array, and may be a set of photodetectors, such as a single avalanche photo diode (SPAD), or a single photon detector (APD: Avalanche Photo Diode). An embodiment of the invention may be implemented using a single photon photodetector. The first and second sensor arrays (26, 36) measure a light pulse, i.e., light corresponding to an image pixel, through the first and second receiving optical systems (25, 35). For example, the first and second sensor arrays (26, 36) may be arranged as a two-dimensional SPAD array having M rows and N columns. Here, M and N may be 2 or more. Also, each SPAD sub-array may be grouped in plurality to form a light sensor. For example, the first and second sensor arrays (26, 36) may be in Geiger mode, i.e., Geiger mode APD (GmAPD).

The main processor (111) performs signal processing to obtain information about an object using the light detected from the first and second sensing modules (123, 133). The main processor (111) determines the distance to the object based on the flight time of the light reflected from the object, and processes data for analyzing the position and shape of the object. The information analyzed by the processor (111), that is, information about the shape and position of the object, may be transmitted to another device.

The first and second transmitting optical systems (22, 32) refract the light pulses generated through the first and second light source arrays (21, 31) and irradiate them toward an object. The light pulses are incident on and reflected from the surface of the object, and the reflected light pulses may be sensed by the first and second sensor arrays (26, 36) through the first and second receiving optical systems (25, 35). Based on the elapsed time (TOF: Time of Flight) from the emission of the light pulses to the detection of the reflected light pulses, the distance or depth to the object may be determined. The LIDAR device (100) may provide a scene or situation around the vehicle using the acquired data. Also, the LIDAR device (100) may be combined with one or more image data acquired from the camera unit (101) to obtain additional insight.

As shown in FIG. 3, a first transceiver (120) is arranged on one side of a central axis (Y0) passing through a first horizontal direction (Y) of a LIDAR device (100), and a second transceiver (130) is arranged on the other side. Since the first and second transceivers (120, 130) are distributed and arranged on both sides of the central axis (Y0), the weight balance or rotational balance of the LIDAR device (100) may be maintained. The central axis (Y0) may be a straight line passing through the center between the two sides of the second direction (X) of the LIDAR device (100).

The first transceiver (120) transmits and receives the first laser beam (L1) in the first direction (Y). The first transceiver (120) transmits and receives the second laser beam (L2) in the opposite direction to the first direction (Y). Accordingly, optical interference resulting from the transmission and reception of the first and second laser beams (L1, L2) may be blocked. Also, the distance between the first transmitting optical system (22) and the second transmitting optical system (32) may be further apart than the distance between the first and second receiving optical systems (25, 35).

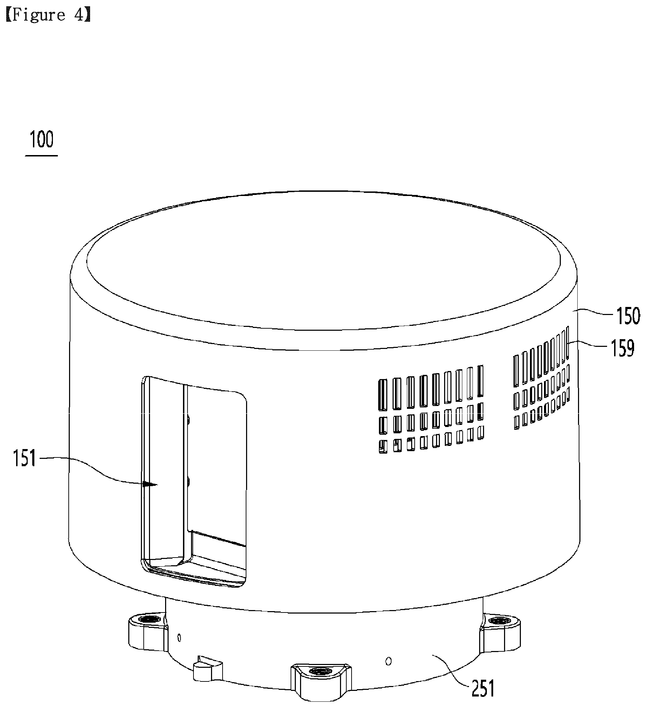

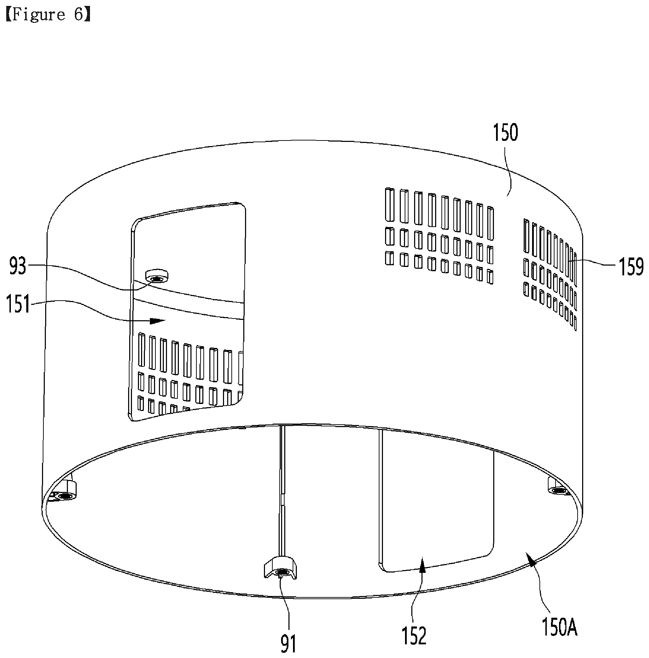

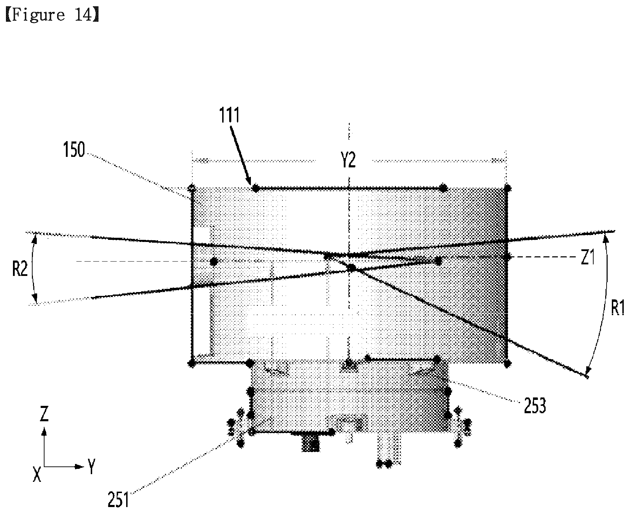

As shown in FIGS. 4 to 8, the LIDAR device (100) may comprise a fixed frame (251), a rotating frame (253, see FIG. 14), a housing (150), a main frame (170) and a transceiver (120, 130) in the internal space (150A) of the housing (150).

The fixed frame (251) comprises a stator inside and may be fixed to a cover or upper case of a vehicle or a mobile body. The fixed frame (251) has a fastening member (12) along the outer periphery and may be coupled to a vehicle such as a mobile body using a plurality of fastening members (11). The fixed frame (251) may comprise a circular shape or a ring shape in a top view.

As shown in FIG. 14, the rotating frame (253) is opposed to the internal structure of the fixed frame (251), has a rotor (not shown), and may rotate on the fixed frame (251). The stator may be a coil, and the rotor may be a coil. The stator and the rotor may constitute a driving unit, for example, a motor. One or more structures may be arranged in the rotating frame (253) and the fixed frame (251) to guide the rotation of the rotating frame (253) and prevent it from being dislodged. The structures may comprise a rotation guide or a rotation axis (not shown). The rotating frame (253) may have a top view shape including a circular shape or a ring shape. The rotating frame (253) may be a rotating platform.

As shown in FIGS. 4 to 6, the housing (150) may have an internal space (150A) and may have a cylindrical shape with an open bottom and a closed top. The housing (150) may extend to the upper outer side of the rotating frame (253). The housing (150) may rotate together with the rotating frame (253). The housing (150) may function as an enclosure covering internal components and may be formed of a heat dissipation member.

A plurality of perforations (159) may be arranged in a predetermined area of the circumferential surface of the housing (150) for heat dissipation. The perforations (159) may be arranged in a plurality in the vertical direction and the rotational direction in at least two areas. The perforations (159) may be formed with the same size or at least one or more sizes may be different.

The housing (150) may comprise a window hole (151, 152). The window hole (151, 152) is formed with a predetermined size between the top and bottom of the housing (150), and may be, for example, larger than the size of the window (191, 192) through which light of each transceiver (120, 130) is transmitted and received. The window hole (151, 152) is arranged in the entrance area of each window (191, 192) and may expose the window (191, 192).

A rotating head part (111) is coupled to the upper part of the rotating frame (253) and the inside of the housing (150). The rotating head part (111) may be provided in a cylindrical shape and rotates together with the rotating frame (253). The cover frame (141) of the rotating head part (111) blocks the inflow of foreign substances into the internal space where internal components, such as the transceiver (120, 130) and other components, are accommodated. The cover frame (141) may have a circular or polygonal shape, and may be made of a metal frame material or a transparent plastic material.

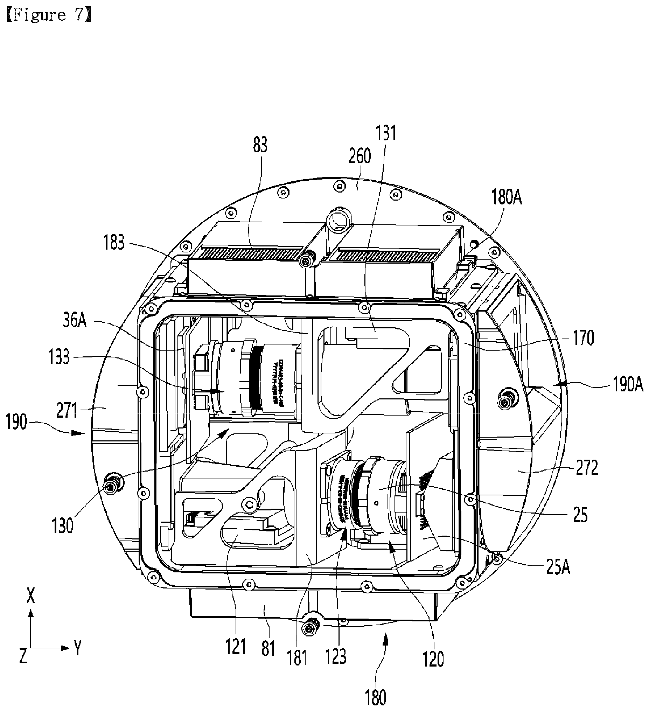

The cover frame (141) may be laminated in one or more pieces and may be tightly coupled with the main frame (170) as shown in FIG. 7. Here, the close joint is joined by having a molded structure or a step structure in the two structures to be joined. The close joint may be joined by a plurality of fastening members, and may comprise a sealing member to prevent moisture penetration from the outside.

The bottom frame (260) supports the components of the rotating head part (111). The bottom frame (260) may be circular in shape and may be provided with a diameter larger than that of the fixed frame (251). The bottom frame (260) may be one or more laminated. The bottom frame (260) may have an area larger than the floor area of the main frame (170) as shown in FIG. 7.

The cover frame (141) may be fastened to a first fastening part (93) arranged on the inner upper periphery of the housing (150) by a fastening member (not shown). The bottom frame (260) may be fastened to a second fastening part (91) arranged on the inner lower periphery of the housing (150) by a fastening member (not shown). The cover frame (141) may have a different shape from or the same shape as the cover frame (161) described below, and either one may be removed.

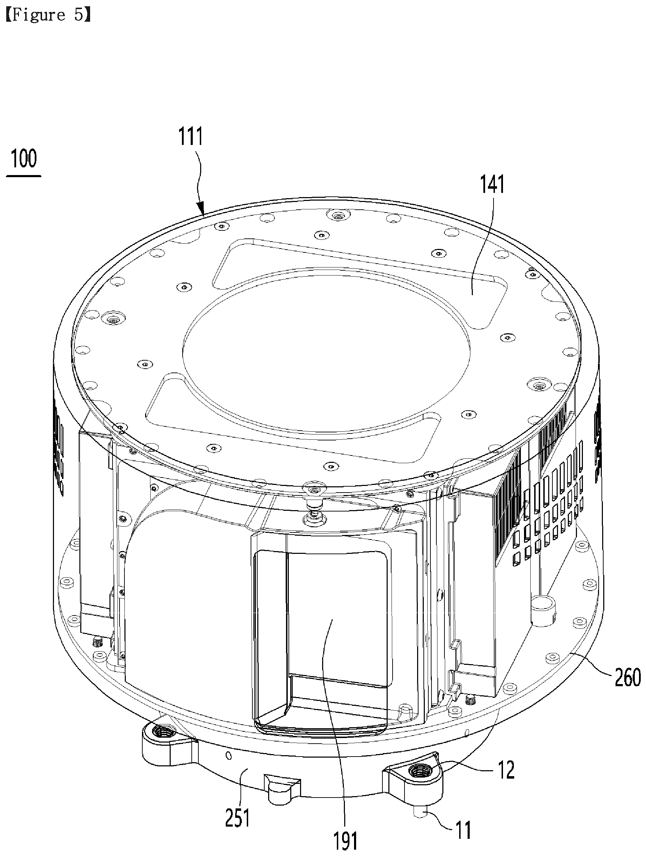

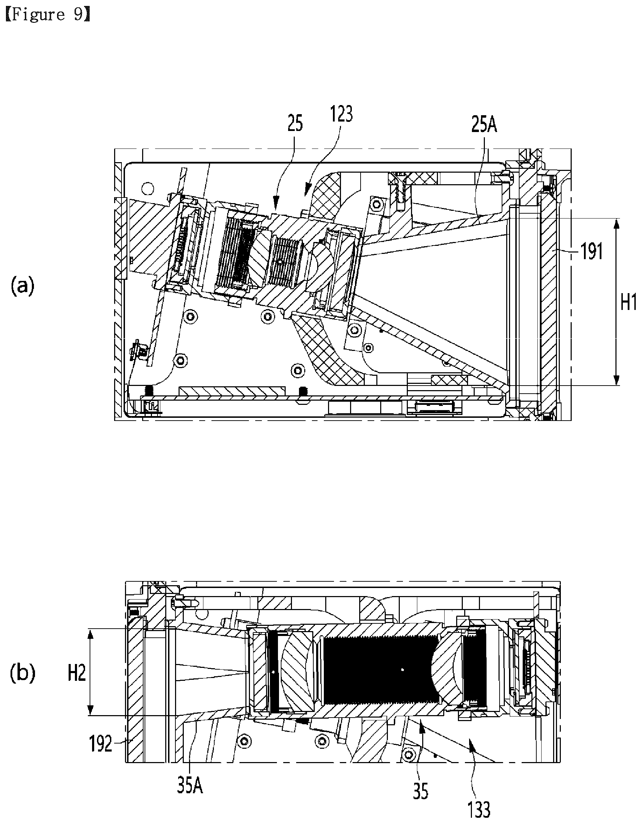

As shown in FIGS. 7 to 12, the LIDAR device (100) may have optical elements such as transceivers (120, 130), heat dissipation elements for heat dissipation, frame elements for supporting and combining internal components, and cover elements for protecting internal components combined inside the housing (150). The rotating head unit (111) illustrated in FIG. 5 may comprise optical elements, heat dissipation elements for heat dissipation, frame elements for supporting and combining internal components, and cover elements for protecting internal components.

The optical element comprises first and second transceivers (120, 130). The first transceiver (120) may comprise one or more circuit boards (21A, 26A, 26B) electrically connected to the first light source array (21) and/or the first sensor array (26). The first sensor array (26) may be disposed on the first circuit board (26A), and the first light source array (21) may be disposed on another driver board (21A). The first transceiver (120) may be disposed on the first main board (26B), and the first main board (26B) may be electrically connected to the boards.

The second transceiver (130) may comprise one or more circuit boards (31A, 36A, 36B) electrically connected to the second light source array (31) and/or the second sensor array (36). The second sensor array (36) may be disposed on the second circuit board (36A), and the second light source array (31) may be disposed on another driver board (31A). The second transceiver (130) may be disposed on the second main board (36B), and the second main board (36B) may be electrically connected to the boards.

The first circuit board (26A) may be arranged between the first receiving optical system (25) and the main frame (170). The second circuit board (36A) may be arranged between the second receiving optical system (35) and the main frame (170). The first circuit board (26A) and the second circuit board (36A) may be arranged on opposite sides of the main frame (170). In this way, by arranging the first and second transceivers (120, 130) in opposite directions, the light source array, the sensor array, and the circuit boards of each transceiver may be distributed. This improves heat dissipation efficiency and maximizes space utilization. In addition, by providing a cooling system having heat dissipation members on at least three sides of each transceiver (120, 130), the problem of heat dissipation degradation may be improved. The problem of performance degradation of the LIDAR system due to heat generated internally may be prevented.

The first transceiver (120) may comprise a first lens hood (25A) that receives light on the incident side (front) of the first receiving optical system (25). The second transceiver (130) may comprise a second lens hood (35A) that receives light on the incident side (front) of the second receiving optical system (35). The shape or area of the entrance side of the first lens hood (25A) may be different from the shape or area of the entrance side of the second lens hood (35A). The first lens hood (25A) may be a part of the first receiving optical system (25). The second lens hood (35A) may be a part of the first receiving optical system (35).

Here, the first transceiver (120), the first lens hood (25A), and the circuit board (21A, 26A, 26B) may be defined as a first transceiver assembly. The second transceiver (130), the second lens hood (35A), and the circuit board (31A, 36A, 36B) may be defined as a second transceiver assembly. The first and second lens hoods (25A, 35A) may be lens tubes.

The first lens hood (25A) extends between the first lens of the first receiving optical system (25) and the first window (191), and may improve incident efficiency and protect the lenses. The second lens hood (35A) extends between the first lens of the second receiving optical system (35) and the second window (192), and may improve incident efficiency and protect the lenses.

The vertical opening height (H1) of the first lens hood (25A) may be different from the vertical opening height (H2) of the second lens hood (35A). For example, the vertical opening height (H1) of the first lens hood (25A) may be greater than the vertical opening height (H2) of the second lens hood (35A). The horizontal opening length (H3) of the first lens hood (25A) may be different from the horizontal opening length (H4) of the second lens hood (35A). For example, the horizontal opening length (H3) of the first lens hood (25A) may be smaller than the horizontal opening length (H4) of the second lens hood (35A). When viewed in cross-section, a first optical axis passing through the center of the first lens hood (25A) and the centers of the internal lenses may be inclined with respect to a second optical axis passing through the center of the second lens hood (35A) and the centers of the internal lenses. The second optical axis is a horizontal optical axis, and the first optical axis may be inclined with respect to the second optical axis.

The first light source array (21) may be placed on the outside of the first lens hood (25A), and the second light source array (31) may be placed on the outside of the second lens hood (35A).

The vertical field of view of the first receiving optical system (25) may be different from the vertical field of view of the second receiving optical system (35). For example, the vertical field of view of the first receiving optical system (25) may be larger than the vertical field of view of the second receiving optical system (35). The horizontal field of view of the first receiving optical system (25) may be different from the horizontal field of view of the second receiving optical system (35). For example, the horizontal field of view of the first receiving optical system (25) may be smaller than the horizontal field of view of the second receiving optical system (35). In addition, the horizontal field of view and the horizontal field of view of the first receiving optical system (25) may be different from each other. The horizontal field of view and the vertical field of view of the second receiving optical system (35) may be the same. That is, one of the plurality of transceivers (120, 130) may have different horizontal and vertical field of view, and the other may have the same horizontal and vertical field of view.

The first receiving optical system (25) of the first transceiver (120) may be arranged to extend from the third side to the fourth side of the main frame (170). The second receiving optical system (35) of the second transceiver (130) may be arranged to extend from the fourth side to the third side of the main frame (170). The third and fourth sides may be opposite sides of the first direction (Y) of the main frame (170), and the first and second sides may be opposite sides of the second direction (X) of the main frame (170). Each of the first to fourth sides of the main frame (170) has a penetrated storage part, and frames having elements for heat dissipation, i.e., heat dissipation members, may be combined in the storage parts of each side.

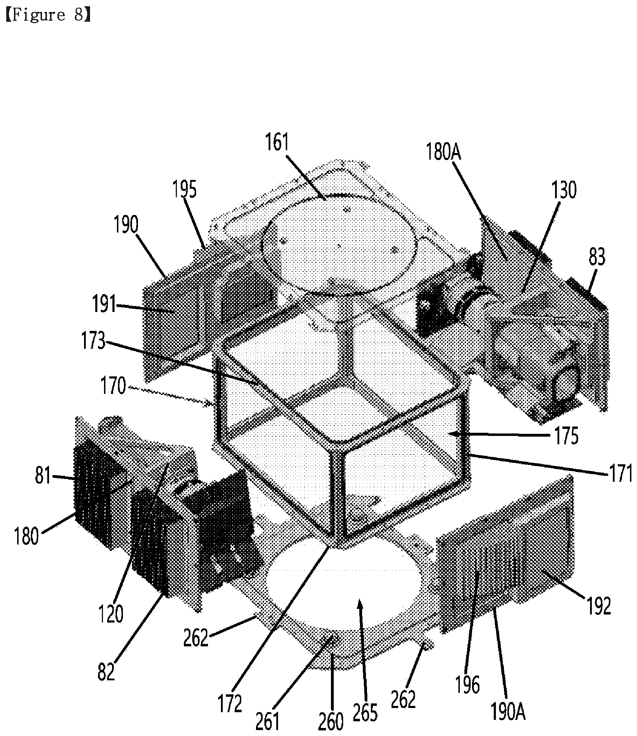

As shown in FIG. 8, the main frame (170) may comprise a storage part (175) that accommodates the first transceiver (120) and the second transceiver (130) therein. The main frame (170) may comprise a plurality of pillar frames (171), a lower frame (172), and an upper frame (173). The upper frame (173), the lower frame (172), and the pillar frame (171) comprise a plurality of storage parts, i.e., fascias, and may comprise, for example, six storage parts or fascias.

The upper frame (173), the lower frame (172), and the plurality of pillar frames (171) may be provided integrally. As another example, at least one of the upper frame (173), the lower frame (172), and the plurality of pillar frames (171) may be provided as a separable structure. The upper frame (173) or the lower frame (172) may be provided separately from each other, and the plurality of pillar frames (171) may be coupled to the upper frame (173) or the lower frame (172). At least one of the upper frame (173), the lower frame (172), and the plurality of pillar frames (171) may be coupled in a fastening or detaching manner.

The upper frame (173) and the lower frame (172) are separated from each other by the pillar frame (171) and may have a polygonal frame shape. The upper frame (173) may have a polygonal shape or a circular shape with a perforated interior. The lower frame (172) may have a polygonal shape or a circular shape with a perforated interior. The upper and lower frames (172) may have the same polygonal shape, for example, a square shape.

The pillar frame (171) may connect and support each corner of the upper and lower frames (172). The upper frame (173), the lower frame (172), and the pillar frame (171) may be formed integrally. As another example, the upper frame (173) may be composed of one or more, or the lower frame (172) may be composed of one or more. In addition, at least one of the upper and lower frames (172) may be combined integrally with the pillar frame (171) or in a combineable structure.

The upper frame (173) has a concave stepped structure on the inner periphery and may guide the joining of the polygonal upper covers (161, 162). The lower frame (172) has a concave stepped structure on the inner periphery and may be joined with the bottom frame (260) having a polygonal shaped molding structure. In addition, each of the pillar frames (171) has a concave stepped structure in the direction of each side of the main frame (170) and may guide the joining of the outer frames.

The main frame (170) may be coupled with first to fourth frames (180, 180A, 190, 190A) in each lateral direction. The first and second frames (180, 18A) may be coupled to both sides of the main frame (170) in the second direction, and the third and fourth frames (190, 190A) may be coupled to both sides of the main frame (170) in the first direction. The first and second frames (180, 180A) may comprise a concave step structure for matching with a step structure arranged along the inner side of both lateral sides of the main frame (170). The third and fourth frames (190, 190A) may comprise a concave step structure for matching with a step structure arranged along the inner side of both lateral sides of the main frame (170).

The third frame (190) has a first window (191) facing the first transmitting and receiving optical system (22, 25), and a third heat dissipation member (195) may be arranged on the outside. The fourth frame (190A) has a second window (192) facing the second transmitting and receiving optical system (32, 35), and a fourth heat dissipation member (196) may be arranged on the outside.

The first frame (180) may have the first transceiver (120) coupled therein, and a first heat dissipation member (81, 81A) may be arranged on the outside. The first heat dissipation member (81, 81A) may be arranged on the entire outside of the first frame (180) or on both sides of the outside surface.

The second frame (180A) may have the second transceiver (130) coupled therein, and a second heat dissipation member (83, 83A) may be arranged on the outside. The second heat dissipation member (83, 83A) may be arranged on the entire outside or both sides of the second frame (180A).

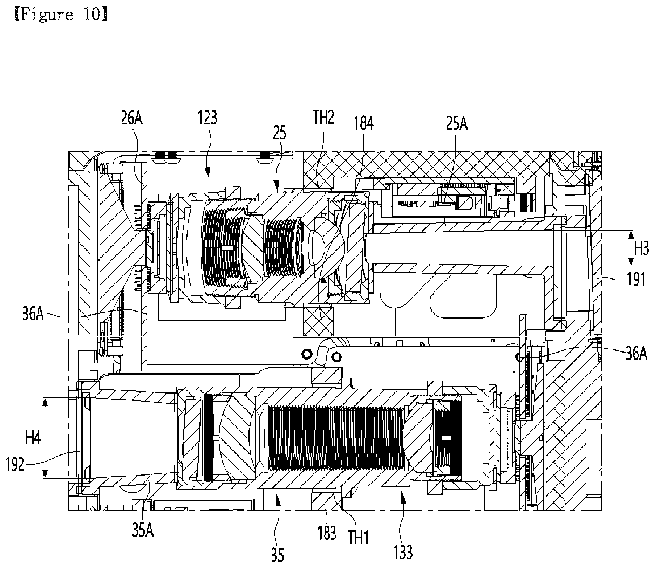

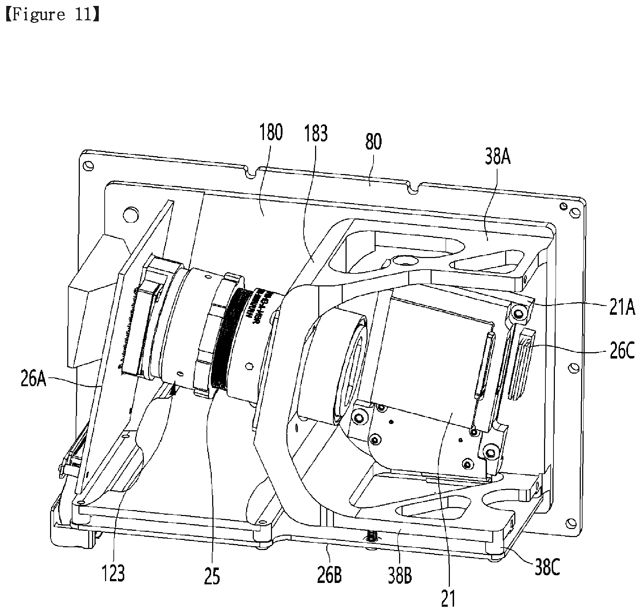

As shown in FIG. 11, the first frame (180) comprises a first support member (183) therein, and the first support member (183) may support a part of the first receiving optical system (25). The first support member (183) has a first barrel hole (TH1, FIG. 10), and when the first receiving optical system (25) is inserted into the first barrel hole (TH1), the position of the first receiving optical system (25) may be fixed and supported.

The second frame (180A) comprises a second support member (184) therein, and the second support member (184) may support a part of the second receiving optical system (35). The second support member (184) has a second barrel hole (TH2, FIG. 11), and when the second receiving optical system (35) is inserted into the second barrel hole (TH2), the position of the second receiving optical system (35) may be fixed and supported. A locking means may be further provided on the inner or outer side of the first and second barrel holes (TH1, TH2) to fix each receiving optical system, and the locking means may comprise a fastener.

The first and second support members (183, 184) may be provided with at least one of a heat-conductive metal material, such as an iron alloy, an aluminum alloy, and a magnesium alloy. The first and second support members (183, 184) may be provided as a mounting device for a circuit board, and may improve heat dissipation efficiency in an internal space. In addition, cooling fins may be further comprised on the outer side of the first and second support members (183, 184).

The first frame (180) may comprise a first protection member (38A) extending upward from the first support member (183) of the first light source array (21) and a second protection member (38B) extending downward. The first and second protection members (38A, 38B) may be bent from the first support member (183), and the second protection member (37B) may be spaced from the first main substrate (26B) by a spacer (38C). The gap between the first and second protection members (38A, 38B) is larger than the outer diameter of the first lens hood (25A), and may protect the lens hood (25A).

The second frame (180A) may comprise a third protection member (48A) extending upward from the second support member (184) of the second light source array (31) and a fourth protection member (48B) extending downward, as shown in FIG. 14. The third and fourth protection members (48A, 48B) may be bent from the second support member (184), and the fourth protection member (48B) may be spaced from the second main substrate (36B) by a spacer (48C). The gap between the third and fourth protection members (48A, 48B) is larger than the outer diameter of the second lens hood (35A), and may protect the second lens hood (35A).

Also, the first and second protection parts (38A, 38B) and the third and fourth protection parts (48A, 48B) of the first and second support parts (183, 184) have holes inside, so that the weight of the frame may be suppressed from increasing.

The first support member (183) may be integrally formed on the inside of the first frame (180) or may be separately attached. The second support member (184) may be integrally formed on the inside of the second frame (180A) or may be separately attached.

The inner perimeter of the first frame (180) has a stepped structure and may be coupled to the third side of the main frame (170). The inner perimeter of the second frame (180A) has a stepped structure and may be coupled to the fourth side of the main frame (170).

The main frame (170) may be coupled with one or more upper covers (161). The periphery of the upper cover (161) may be inserted into or closely attached to the upper frame (173) of the main frame (170). The upper cover (161) may have a plurality of fastening holes on the inside or the periphery, and may be fastened with frames coupled with the main frame (170). The upper cover (161) may be transparent. The upper cover (161) may be fastened to a fastening portion on the inside of the housing (150). The upper cover (161) may be circular or polygonal. That is, the upper cover (161) may have a circular shape identical to the upper shape of the housing (150). As another example, the upper cover (161) may have a polygonal shape identical to the upper shape of the main frame (170).

The main frame (170) may be coupled with the bottom frame (260). The bottom frame (260) may support the lower portions of the first and second transceivers (120, 130). The bottom frame (260) may be coupled with the rotating frame (253). The bottom frame (260) has a coupling hole inside and a coupling protrusion on the upper circumference, and may be formed to be in close contact with the lower frame (172) of the main frame (170) by the stepped structure on the upper circumference. Accordingly, the lower frame (172) may be in close contact with the circumference of the bottom frame (260).

The joining hole of the bottom frame (260) may be protruded from the upper structure of the rotating frame (253) and may be joined to the configuration or/and support elements of the main frame (170). That is, in order to prevent movement due to rotation, another frame or/and a side cover may be joined on the joining hole of the bottom frame (260). Here, a plurality of frames (180, 180A, 190, 190A) may be joined to each side of the main frame (170). The plurality of frames may be first to fourth frames (180, 180A, 190, 190A) arranged on each side of the main frame (170).

The bottom frame (260) has a circular or polygonal external shape and may be combined with the first to fourth frames (180, 180A, 190, 190A) using the connecting protrusions (262) protruding outwardly on each side. The bottom frame (260) has a plurality of insertion protrusions (261) on the inner circumference and may be combined with holes (not shown) of the main substrate (26B, 36B). These insertion protrusions (261) and connecting protrusions (262) can prevent individual movement of the bottom frame (260).

The bottom frame (260) may be coupled to the bottom of the housing (150). That is, the bottom frame (260) may have a circular shape identical to the lower shape of the housing (150). As another example, the bottom frame (260) may have a polygonal shape identical to the lower shape of the main frame (170).

A sealing member may be placed between the main frame (170) and the bottom frame (260), between the main frame (170) and the upper cover (161), and between the main frame (170) and the first to fourth frames (180, 180A, 190, 190A). The sealing member is a cleaning element, comprises a rubber material, and can block moisture and foreign substances from entering through each side of the main frame (170).

The first heat dissipation member (81, 81A) may be arranged on one side of the first circuit board (26A) and one side of the first light source array (21). The first heat dissipation member (81, 81A) may be arranged between the housing (150) and the main frame (170). The second heat dissipation member (83, 83A) may be arranged on one side of the second circuit board (36A) and one side of the second light source array (31). The second heat dissipation member (83, 83A) may be arranged between the housing (150) and the main frame (170). The first heat dissipation member (81, 81A) and the second heat dissipation member (83, 83A) may comprise vertically arranged heat dissipation fins. The second heat dissipation member (83, 83A) may comprise vertically arranged heat dissipation fins.

The third heat dissipation member (195) is disposed outside of the first sensor array (26), that is, outside of the first circuit board (26A) on which the first sensor array (26) is disposed, and dissipates heat generated from the first sensor array (26). The fourth heat dissipation member (196) is disposed outside of the second sensor array (36), that is, outside of the second circuit board (36A) on which the second sensor array (36) is disposed, and dissipates heat generated from the second sensor array (36). The third and fourth heat dissipation members (195, 196) may have vertical heat dissipation fins formed therein. The area of each of the third and fourth heat dissipation members (195, 196) may be smaller than the area of each of the first and second heat dissipation members (81A, 83A). The area of each heat dissipation member is the size of the area on which each heat dissipation fin is arranged.

The first to fourth heat dissipation members (81A, 83A, 195, 196) may be positioned inside the housing (150). The heat dissipation fins of the third and fourth heat dissipation members (195, 196) may have a width (horizontal width) that gradually decreases in the rotational direction, and their vertical lengths may be the same. The first window hole (151) faces the first receiving optical system (22) and the first light source array (21) of the first transceiver (120). The second window hole (152) may face the second receiving optical system (32) and the second light source array (31) of the second transceiver (130). The first and second windows (191, 192) may be coupled to the coupling holes of the third and fourth frames (190, 190A), respectively.

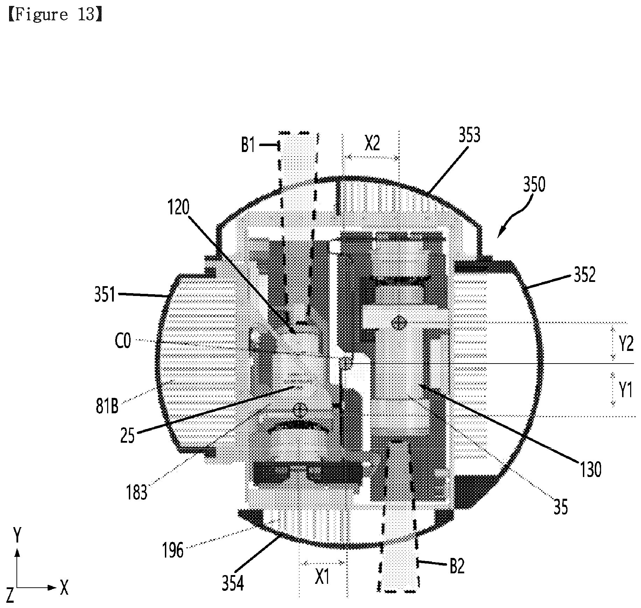

As shown in FIG. 13, the first transceiver (120) may scan and sense in a first beam shape (B1), and the second transceiver (130) may scan and sense in a second beam shape (B2). At least one or both of the first and second transceivers may be provided without a lens hood.

From the center (C0) of the LIDAR device, the center of the first receiving optical system (25) and the center of the second receiving optical system (35) may be spaced apart by the same distance (Y1, Y2) in the first direction (Y). From the center of the LIDAR device, the center of the first receiving optical system (25) and the center of the second receiving optical system (35) may be spaced apart by the same distance (X1, X2) in the second direction (X). In the case of the center positions of the first and second receiving optical systems (25, 35), the centers of gravity of each of the first and second transceivers (120, 130) may be spaced apart equally in the first and second directions (Y, X), so that the centers of gravity of each transceiver may be arranged to be diametrically opposite to the center of rotation.

FIG. 13 is another example of an inner cover and a heat dissipation member in an embodiment of the invention. As shown in Fig. 13, the LIDAR device may further comprise an inner cover (350) inside the housing (150). The inner cover (350) may be in close contact with the outer surfaces of the first to fourth heat dissipation members (81B, 83A, 195, 196).

The inner cover (350) comprises a heat dissipation cover (351, 352, 353, 354) on the outer side of each heat dissipation member (81B, 83A, 195, 196) of the main frame (370). The heat dissipation cover (351, 352, 353, 354) may be arranged on the inner side of the housing (150). The heat dissipation cover (351, 352, 353, 354) may be arranged between the housing (150) and the heat dissipation members (81B, 83A, 195, 196). The heat dissipation cover (351, 352, 353, 354) may be provided in a curved shape on the outer side of each heat dissipation member (81B, 83A, 195, 196). For example, a first heat dissipation cover (351) may be comprised on the outside of the first heat dissipation member (81B), a second heat dissipation cover (352) may be comprised on the outside of the second heat dissipation member (83A), a third heat dissipation cover (353) may be comprised on the outside of the third heat dissipation member (195), and a fourth heat dissipation cover (354) may be comprised on the outside of the fourth heat dissipation member (196).

The first heat dissipation cover (351) may be coupled to one side of the main frame (370) with a hemispherical shape. The second heat dissipation cover (352) may be coupled to the other side of the main frame (370) with a hemispherical shape. Here, the first, third, and fourth heat dissipation members (81B, 195, 196) may have different horizontal lengths so that the outer shapes of the heat dissipation fins face the hemispherical heat dissipation covers (351, 353, 354).

Adjacent heat dissipation covers (351, 352, 353, 354) may be coupled to each other or coupled through a main frame (370). Also, the main frames (370) may be separated into a plurality of pieces and coupled to each other by fastening members. Also, the main frame (370) may be composed of frames (371, 372, 373, 374) arranged on each side. In this case, the number of frames may be reduced by arranging the main frame (370) or each side frame. The two ends of the third frame (190) may be bent so that the outer ends of the third and fourth frames face each other.

Each of the heat dissipation covers (351, 352, 353, 354) may cover the outer side, side surface, and upper surface of each heat dissipation member (81B, 83A, 195, 196).

As shown in FIG. 14, on the outside of the housing (150), the first transceiver (120) may have a first vertical angle of view (R1), and the second transceiver (130) may have a second vertical angle of view (R2). With respect to the horizontal axis (Z1), the second vertical angle of view (R2) may be smaller than the first vertical angle of view (R1). Here, the vertical angle of view may be an angle between two straight lines extending from the upper and lower ends of the entrance side of each lens hood.

The diameter (Y2) of the housing (150) may be provided to be larger than the diameter of the rotating frame (253) or/and the fixed frame (251).

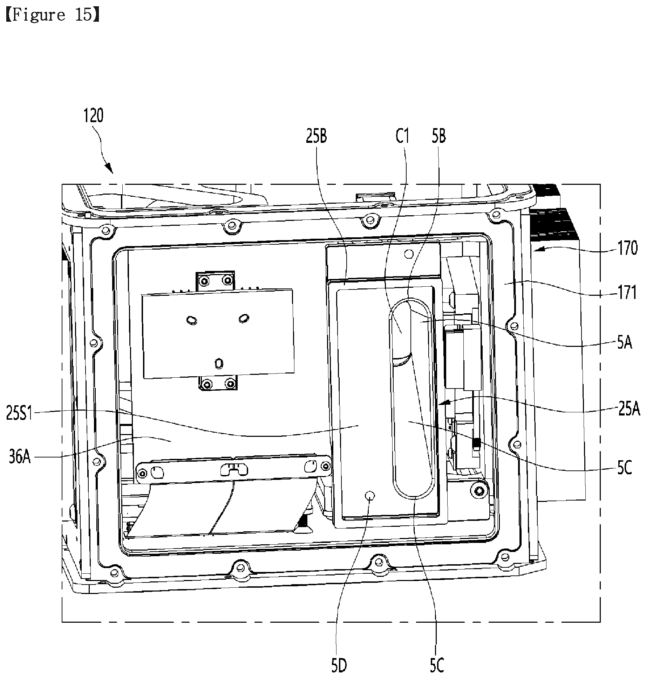

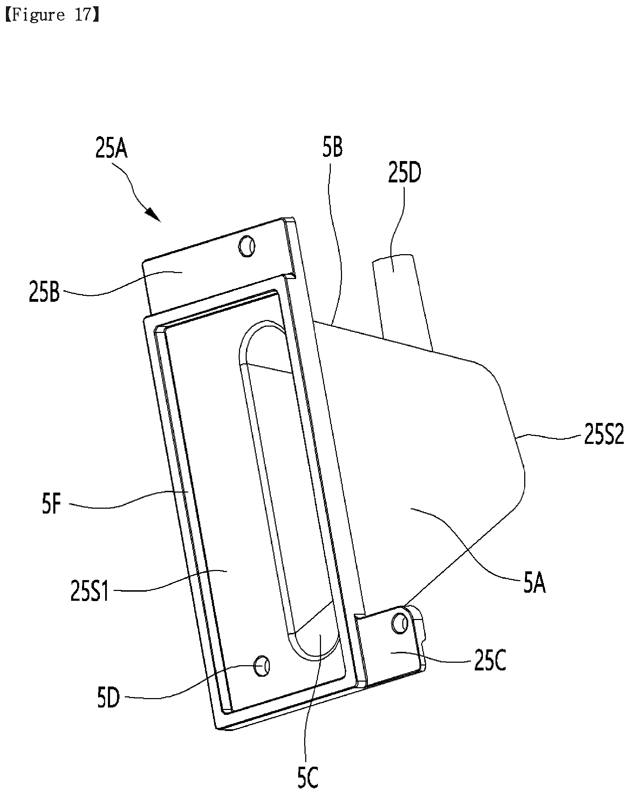

As shown in FIG. 15 and FIG. 17, the end portion (25B) of the first lens hood (25A) and the back surface of the second circuit board (36A) are exposed on the fourth side or one side storage part of the main frame (170). The entrance of the first lens hood (25A) may have a vertical height greater than a horizontal length. The entrance of the first lens hood (25A) may have a left/right symmetry and an upper/lower shape may have an asymmetrical shape.

The end portion (25B) of the first lens hood (25A) exposes the first lens hole (C1), and the gap between the upper end (5B) and the lower end (5C) of the first lens hole (C1) may gradually increase from the inside to the outside. The end portion (25B) of the first lens hood (25A) may be fastened together with the first window (191) by a fastening hole (5D).

The side surface (5A) of the first lens hole (C1) of the first lens hood (25A) may be a curved surface having a radius of curvature greater than the radii of curvature of the upper and lower surfaces (5B, 5C), or may be a vertical plane. The end portion (25B) of the first lens hood (25A) has a stepped region (25S1) between the outer circumference and the first lens hole (C1), and a fastening hole (5D) may be provided on the stepped region (25S1), so that a fastening member such as a screw or bolt may be used to fasten it to another member. The end portion (25B) of the first lens hood (25A) may have an outer circumference (5F) to which an adhesive may be applied, so that it may be bonded to another member. The first lens hood (25A) has a protrusion (25C, 25D) protruding outward, and may be joined or attached to another member through a fastening hole of the protrusion (25C, 25D). The first window (191) may be arranged at the end portion (25B) of the first lens hood (25A) and the emission side of the first light source array (21).

The shape of the entrance side of the first lens hole (C1) may be an oval shape. As another example, the shape of the entrance side of the first lens hole (C1) may be a circular shape or a polygonal shape such as a square or rectangle.

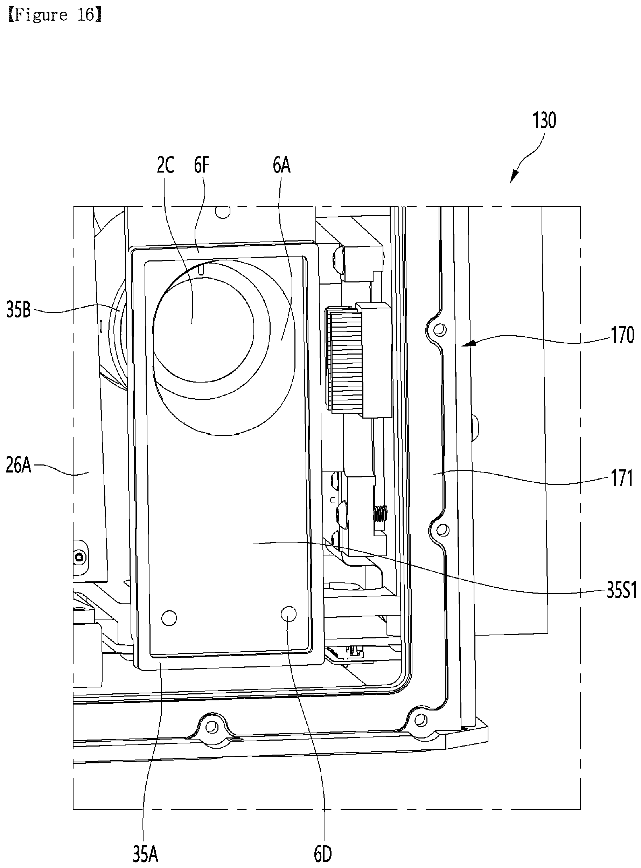

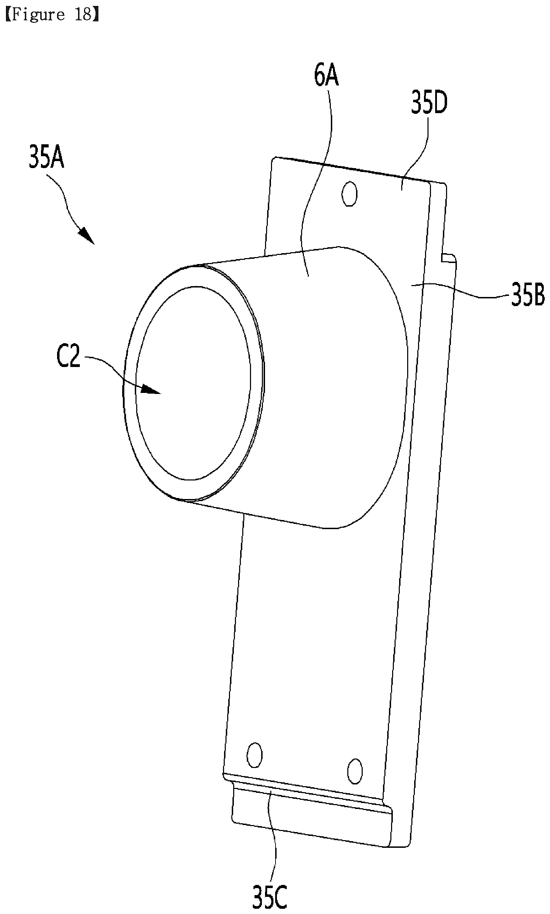

As shown in FIG. 16 and FIG. 18, the end portion (35B) of the second lens hood (35A) and the back surface of the first circuit board (26A) are exposed on the third side or other side storage part of the main frame (170). The entrance of the second lens hood (35A) may have the same or different horizontal length and vertical height. The entrance of the second lens hood (35A) may have a left/right symmetrical shape or/and an up/down symmetrical shape.

The end portion (35B) of the second lens hood (35A) exposes the second lens hole (C2), and the gap between the top and bottom of the second lens hole (C2) may gradually increase from the inside toward the outside. The end portion (35B) of the second lens hood (35A) may be fastened to the second window (192) through the fastening hole (6D) using a fastening member such as a screw or a bolt. The side surface (6A) of the first lens hole (C1) of the second lens hood (35A) may be a curved surface having a larger radius of curvature than the radii of curvature of the upper and lower surfaces. The end portion (35B) of the second lens hood (35A) has a stepped area (35S1) between the outer circumference (6F) and the second lens hole (C2), and a fastening hole (6D) may be provided on the stepped area (35S1), so as to enable bonding with another member. The end portion (35B) of the second lens hood (35A) may have an adhesive applied to the outer circumference (6F), so as to enable bonding with another member. The second lens hood (35A) has a protrusion (35C, 35D) that protrudes outward, so as to enable bonding with another member or close contact with another member through the fastening hole of the protrusion (35D). The second window (192) may be arranged on the end portion (35B) of the second lens hood (35A) and the emission side of the second light source array (31).

The shape of the entrance side of the second lens hole (C2) may be an oval shape. As another example, the shape of the entrance side of the second lens hole (C2) may be a circular shape or a polygonal shape such as a square or rectangle.

The first and second lens hoods (25A, 35A) may be provided with a uniform thickness from one end to the other, and may be manufactured from a polymer material having strength capable of withstanding external vibration. Also, the first and second lens hoods (25A, 35A) may be coated on the inner surface with a light-absorbing material for absorbing stray light. This light-absorbing material may reduce optical interference, improve signal processing, and collect transmitted light. Also, the light-absorbing material may comprise an anti-reflection coating layer as another example. The lens hoods (25A, 35A) of the present invention may be coated with a plurality of different materials for absorbing light in separate layers. Also, the coated material may be composed of a material designed to absorb a specific wavelength of light transmission. For example, the absorbing material may be designed to absorb the material in a predetermined range of wavelengths (e.g., including the wavelength of the transmitted optical signal). That is, the absorptive material may reduce interference by absorbing all other optical signals received outside a given wavelength range and allowing only the desired wavelengths to be received by the receiver.

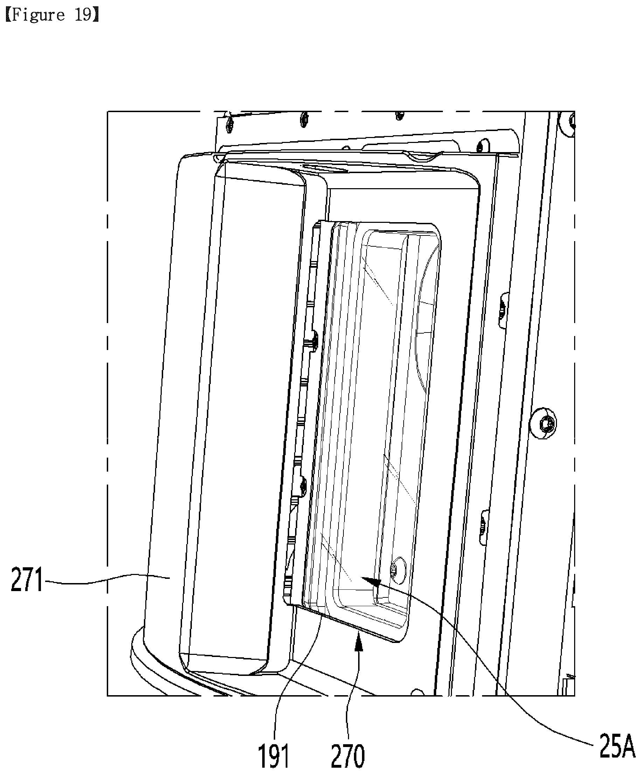

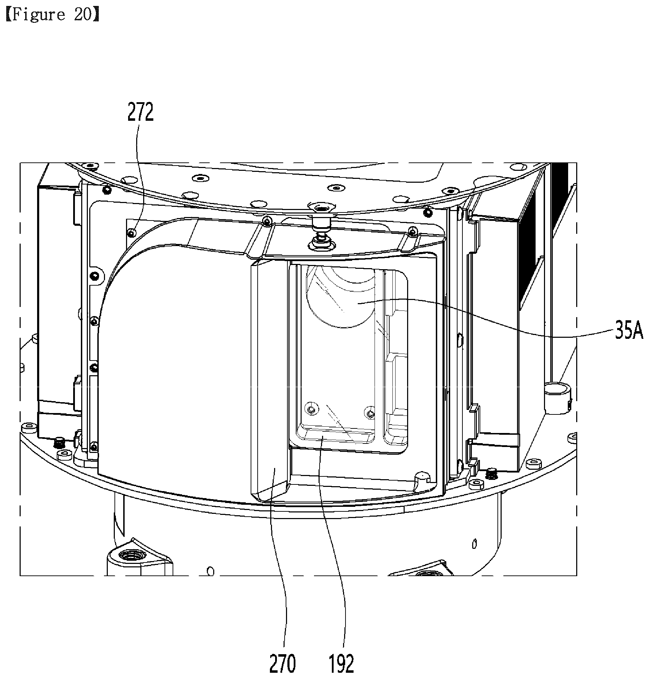

As shown in FIG. 19, a first window (191) is arranged on the incident side of the first lens hood (25A), and the first window (191) may be exposed through the formed hole (270) of the heat dissipation cover (271). As shown in FIG. 20, a second window (192) is arranged on the incident side of the second lens hood (35A), and the second window (192) may be exposed through the formed hole (270) of the heat dissipation cover (272). Also, the heat dissipation cover (272) may be fastened to the main frame by a fastening member.

The shape of the lens hood (25A, 35A) in the invention can eliminate any occlusion in the transmitter and receiver. For example, the lens hood of the receiver may be designed to collimate the received optical signal and absorb stray light and other signals while eliminating blind spots or occlusions in front of the receiver. The inner coating of the disclosed lens hood can act to filter out signals with different phases. Also, the sensor array may have a corresponding shape of the lens hood to receive the return signal. In another example, the light source array may be configured to emit an optical signal through each lens hood. Also, the lens hood of the transceiver may be configured to have a vertically elongated rectangular shape to correspond to the shapes of both the emitted optical signal and the reflected optical signal.

The features, structures, effects, etc. described in the embodiments are comprised in at least one embodiment of the present invention, and are not necessarily limited to one embodiment. Furthermore, the features, structures, effects, etc. illustrated in each embodiment may be combined or modified and implemented in other embodiments by a person having ordinary knowledge in the field to which the embodiments belong. Therefore, the contents related to such combinations and modifications should be interpreted as being comprised in the scope of the present invention. Also, although the embodiments have been described, they are merely examples and do not limit the present invention. A person having ordinary knowledge in the field to which the present invention belongs will understand that various modifications and applications not illustrated are possible without departing from the essential characteristics of the embodiments. For example, each component specifically shown in the embodiments may be modified and implemented. And the differences related to such modifications and applications should be interpreted as being comprised in the scope of the present invention defined in the appended claims.

## Claims

1. A LIDAR device comprising
a main frame having a storage part inside;
a plurality of transceivers arranged in the storage part, each irradiating a laser beam toward an object in different directions and each sensing a laser beam reflected from the object;
a bottom frame arranged below the main frame; and
a plurality of lens hoods arranged on the incident side of the receiving optical system of each of the plurality of transceivers.

2. The LIDAR device of claim 1,
wherein the plurality of transceivers comprise a first transceiver having a first light source array irradiating a laser beam in a first direction, and a first receiving optical system and a first sensor array for receiving the laser beam of the first light source array and a second light source array irradiating a laser beam in a direction opposite to the first direction, and a second transceiver having a second receiving optical system and a second sensor array for receiving the laser beam of the second light source array,
the plurality of lens hoods comprise a first lens hood arranged on the incident side of the first receiving optical system, and a second lens hood arranged on the incident side of the second receiving optical system.

3. The LIDAR device of claim 2,
wherein the LIDAR device comprises a first window arranged on the incident side of the first lens hood and the emission side of the first light source array, and a second window arranged on the incident side of the second lens hood and the emission side of the second light source array.

4. The LIDAR device of claim 2,
wherein the first and second windows are positioned outside the main frame.

5. The LIDAR device of any one of claim 1 to 4,
wherein each side of the main frame has a penetrated storage part, and comprises frames having heat dissipation members coupled to the storage parts on each side of the main frame.

6. The LIDAR device of any one of claim 1 to 4,
wherein the sizes of the entrances through which laser beams of the plurality of lens hoods are incident may be different from each other.

7. The LIDAR device of any one of claim 2 to 4,
wherein the end-side lens hole of the first lens hood has a vertical height greater than a horizontal length.

8. The LIDAR device of claim 7,
wherein the end-side lens hole of the second lens hood has the same horizontal length and vertical height..

9. The LIDAR device of any one of claim 2 to 4,
wherein a first optical axis passing through the centers of the first lens hood and the lenses of the first receiving optical system is inclined with respect to a second optical axis passing through the centers of the second lens hood and the lenses of the second receiving optical system.

10. The LIDAR device of claim 5,
wherein the LIDAR device comprises a heat dissipation cover covering each of the heat dissipation members arranged on each side of the main frame, and the heat dissipation cover has a hole exposing the window.

11. The LIDAR device of claim 5,
wherein the LIDAR device comprises a housing covering the upper and outer sides of the main frame, the housing having window holes corresponding to the holes of each of the heat dissipation covers.

12. The LIDAR device of any one of claim 1 to 4,
wherein the LIDAR device comprises a fixed frame having a stator and being fixed to a moving body; and a rotating frame having a rotor opposite to the stator and rotating about an axis on the fixed frame.

13. The LIDAR device of any one of claim 1 to 4,
wherein among the multiple transceivers, the reception angles incident through each transceiver are different from each other.
